# EUROPEAN PATENT SPECIFICATION

(11) **EP 0 409 668 B1**
(45) Date of publication and mention of the grant of the patent: **25.01.1995**
(21) Application number: 90308039.8
(22) Date of filing: 23.07.1990
(51) Int. Cl.: H05K 1/16, H05K 3/20

(54) **Mixed circuit boards and a method for manufacture thereof**
Mischleiterplatten und Verfahren zu ihrer Herstellung
Circuits imprimés composites et leur méthode de fabrication

(30) Priority: 21.07.1989 JP 190205/89
(43) Date of publication of application: 23.01.1991
(73) Proprietor: OMRON CORPORATION, Kyoto 616 (JP)
(72) Inventor: Kawai, Wakahiro, Kurita-gun, Shiga (JP); Kita, Motohiro, Nagaokakyo-shi (JP); Matsuda, Katsumi, Kita-ku, Kyoto (JP)
(74) Representative: Calderbank, Thomas Roger

(56) References cited:
- EP-A- 0 283 239
- CH-A- 297 158
- DE-A- 3 639 604
- GB-A- 999 183

## Description

The present invention relate to a mixed circuit board for high-density mounting of electronic components and a method for their manufacture.

The following general techniques are known for the mounting of electronic components on a circuit board.

The first technique is the so-called "double-sided mounting" which comprises using both sides of a printed board for reducing the specific surface area necessary for wiring relative to the area occupied by electronic components. With the reduced bulk of electronic components, the area occupied by electronic components on the printed circuit board has been decreased and in order to reduce the ratio of the area required for wiring, the smaller printed conductor widths have been employed. These measures have allowed the board to be compatible with the increased compactness of electronic components with some success and, at the same time, permitted suppression of delays in the transmission of signals in electronic circuits.

The second technique is one developed for a circuit containing a large number of driven elements such as resistors and capacitors in the neighborhood of driver elements, such as an analog-digital mixed circuit. This technique essentially comprises building resistors in the printed circuit board pattern. Such a printed circuit board with built-in or internal resistors is manufactured by a process which comprises plating the effective surface of roughened copper foil with a nickel alloy, subjecting the plated foil to a special treatment for ensuring better adhesion to an insulating synthetic resin substrate, then fabricating a board in the same manner as the usual copper foil laminate and thereafter subjecting the board to two stages of photoetching to form internal resistors with predetermined resistance values. Since this technique builds resistors into a printed circuit pattern, the space required for the mounting of resistors can be dispensed with and the resistor network can be connected to other elements over the shortest possible distances.

The third technique comprises building resistors and capacitors into a ceramic substrate for a still higher mounting density. One exemplary method comprises laminating a green sheet printed with conductors, resistors and internal electrodes to a dielectric green sheet under pressure to provide an integral sheet, cutting the sheet to size and sintering the cut sheet. Another method comprises forming conductors, resistors and insulators by the sputtering technique in succession to provide a laminate.

However, all of these known techniques have the following disadvantages.

Referring, first, to the first-mentioned technology, there is a certain unsurmountable limit to the mounting density of electronic components even if the pattern printing technology and the process for connection of patterned electrodes to electronic components are improved. Thus, if it is attempted to further reduce the pattern width (60 µm) of the printed circuit board, breaks tend to occur in the pattern and this requires rigorous quality control and careful inspection. Furthermore, the connecting technology mentioned above is time consuming and there is a high probability that solder bridges will be formed between adjacent parts which adds to the manufacturing cost of inspecting and correcting such defects.

Referring to the second technology, the heating required for soldering electronic components to electrodes causes changes in resistance values from the pre-heating baselines and even variations in resistance under high-temperature, high-humidity conditions, thus interfering with the stabilised action of the electronic circuit as a whole.

Furthermore, it is only the resistor, among the various driven elements included in an electronic circuit, that is incorporated in the printed pattern and the capacitor, which is as indispensable to a circuit as the resistor must be surface-mounted, thus imposing a limitation on size reduction.

With regard to the third technology and referring to the first-mentioned method, there is a limitation on material selection, for while the sintering temperature for ceramics is as high as 900 to 1,000°C, the conductors are also subjected to the same heat. In the case of the second-mentioned method, the size of the printed circuit board which can be implemented is limited (up to about 10 cm).

Other known technologies also have the drawback of a complicated board structure and, hence, an increased manufacturing cost.

CH-A-297158 discloses a mixed circuit board in which a laminated sheet is mounted on an insulating support. In CH-A-297158, the layers of the laminating sheet are all resistor layers or all semiconductive layers.

According to a first aspect of the present invention there is provided a mixed circuit board comprising a heat-resistant insulating substrate and at least one laminated sheet bonded integrally to at least one side of said substrate;
wherein:
said laminated sheet comprises a metal oxide dielectric film, a metal resistor film on said dielectric film and a pair of metal conductor layers between which said dielectric film and resistor film are sandwiched.

According to a second aspect of the present invention there is provided a mixed circuit board comprising a heat-resistant insulating substrate and at least one laminated sheet bonded integrally to at least one side of said substrate;
wherein:
said laminated sheet comprises a metal oxide dielectric film, a conductive polymer film, a metal resistor film on either said conductive polymer film or said dielectric film and a pair of metal conductor layers between which said dielectric film, said conductive polymer film and resistor film are sandwiched.

According to a third aspect of the present invention there is provided a method for fabricating a mixed circuit board which comprises:
a step of forming a metal oxide dielectric film,
a step of forming a conductive polymer film on the surface of said dielectric film,
a step of forming a metal oxide resistor film on either said dielectric film or said conductive polymer film,
a step of sandwiching said dielectric film, said conductive polymer film and said resistor film between a pair of metal conductor layers,
a step of forming an insulating region by selective etching of at least one of said metal conductor layers in a circuit network formation, and
a step of bonding a laminated sheet consisting of said dielectric film, conductive polymer film, resistor film and metal conductor layers to at least one side of a heat-resistant insulating substrate.

With the present invention , it is then possible to achieve increased mounting density, stable component characteristics and, hence, increased circuit reliability.

In order that the present invention is more clearly understood, embodiments will now be described by way of example only and not by way of limitation with reference to the following drawings:
Fig. 1 is a partially exploded perspective view illustrating an embodiment of the mixed circuit board according to the invention;
Fig. 2 is a diagram showing changes in resistance temperature coefficient on heat treatment at the stage of formation of the resistor layer of a mixed circuit board;
Fig. 3 is a diagram showing the frequency characteristics of impedance when a conductive polymer film was formed on the capacitor in the same mixed circuit board;
Fig. 4a and 4b are schematic views illustrating the manner of integrating laminated sheets with an insulating substrate;
Fig. 5 shows an experimental model for the local conversion of the conductive polymer film into an insulating film;
Fig. 6 is a diagram showing changes in current and voltage in the model of Fig. 5; and
Fig. 7a and 7b are schematic sectional views showing a mode of use of the mixed circuit board.

The preferred embodiments of the present invention are described below, referring to the accompanying drawings.

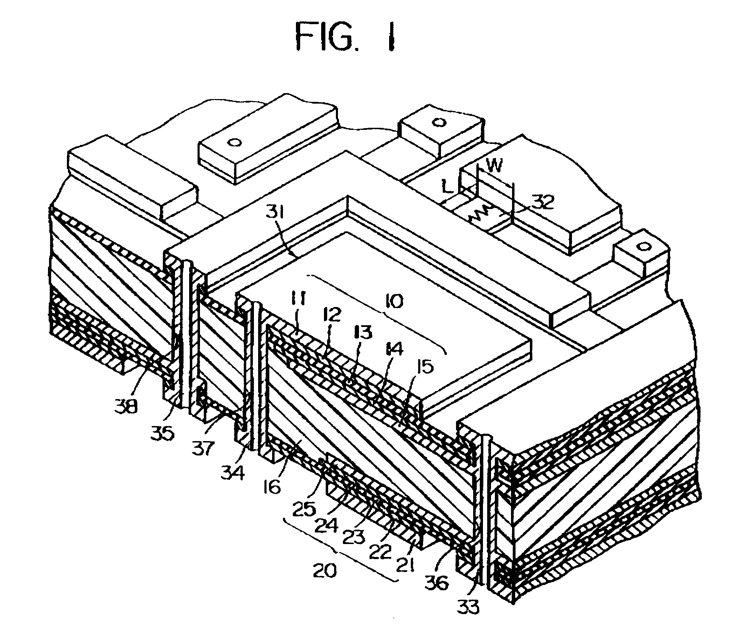

Fig. 1, illustrates an example of the mixed circuit board of the invention. Reference numeral 11 indicates an electrode of PCB copper foil, 12 is a thin resistor film, and 13 is a dielectric film formed on the resistor film 12. The reference numeral 14 indicates a film made of a conductive polymer material and superimposed on the dielectric film 13, and 15 is an electrode counter to the first-mentioned electrode 11. Thus, the resistor film 12, dielectric film 13 and conductive polymer film 14 are sandwiched between the above-mentioned two electrodes 11, 15, and all of these film layers assembled together constitute a first laminated sheet 10. This first laminated sheet 10 is integrally bonded to one side of an insulating substrate 16.

Integrally bonded to the other side of the insulating substrate 16 is a second laminated sheet 20. Just like the first laminated sheet 10, this second laminated sheet is also comprised of electrode 21, resistor film 22, dielectric film 23, conductive polymer film 24 and electrode 25 as laminated in the order mentioned.

The above-mentioned first laminated sheet 10, thus, comprises a pair of electrodes 11,15, a capacitor 31 constituted by the dielectric film 13 and conductive polymer film 14, and a resistor 32 constituted by the resistor film 12. The second laminated sheet 20 includes a capacitor and a resistor (not shown) in the same manner. The reference numerals 33, 34 and 35 represent through holes formed between the first laminated sheet 10 and second laminated sheet 20.

The following is an exemplary fabricating procedure employing Ni-Cr-P alloy for the resistor films 12,22, Ta₂O₅ for the dielectric films 13,23, polypyrrole for the conductive polymer films 14,24, and rolled copper foil for the electrodes 11,21,15, 25, and epoxy resin for the insulating substrate 16. With regard to the two laminated sheets 10,20, only the sheet 10 is referred to in the following description.

As copper foil of PCB grade for electrode 11, rolled copper foil is used which is excellent in flexibility, bond strength and electrical characteristics and has a low content (not more than 0.02%) of oxygen which may cause hydrogen brittleness. However, copper has the disadvantage that copper oxide may form on the surface and has a very poor bonding affinity for other metals. Moreover, because rolled copper foil in particular has a dense, smooth surface, it is extremely poor in adhesiveness to other materials. Therefore, in order to improve its bonding performance by way of anchoring, the foil is roughened in the following manner. The surface roughening is carried out by applying an alternating current between a couple of carbon electrodes set up with the copper foil interposed therebetween in an electrolyte, i.e. an inorganic acid such as hydrochloric acid or nitric acid.

On the surface-treated rolled copper foil, Ni-Cr-P alloy is deposited in a thickness of about 3,000 to 4,000 Å to provide a resistor film 12. This process is performed by the electroless plating technique.

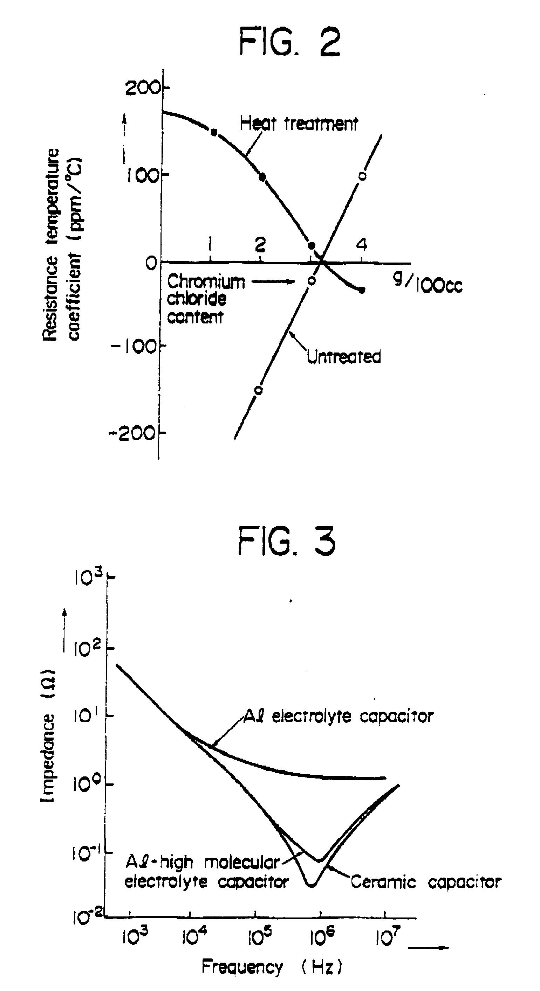

The surface of the rolled copper foil is first sonically washed with isopropyl alcohol as a pretreatment for plating and, then, the foil is dipped in a plating bath prepared by adding chromium chloride and sodium hypochlorite to the usual Ni-P plating solution. Then, for improving the aging characteristic of electrical resistance and the resistance to environment through promotion of crystallization of the resistor film 12, the film is heat-treated for 3 hours at a temperature over the soldering temperatures of 240°C. The effect of this heat treatment is shown as the relationship between chromium chloride content and resistance temperature coefficient. It is seen from the characteristic curve of Fig. 2 that the heat treatment causes a marked gain in resistance temperature coefficient.

It should be understood that, in regard to Fig. 2, the resistance temperature coefficient is equal to 0 at a certain chromium chloride content (3.7 g/100 cc) and that this heat treatment may be omitted by controlling the chromium chloride content of the plating bath in an appropriate manner.

Then, a dielectric film 13 of tantalum oxide Ta₂O₅ is formed on the above Ni alloy resistor film 12. The specific dielectric constant of Ta₂O₅ is relatively high, namely 25. Moreover, it is as stable as the oxide film and shows a small leak current, thus being an excellent dielectric material. Though this oxide film has so far been produced by the anodizing technique using pure Ta as the base metal, the inventors of the present invention could employ a method of forming the film directly without using pure Ta base metal by the utilization of the conductive polymer film 14 as an electrolyte, which eliminated the need for repair of the dielectric film by the oxidative effect of an electrolyte on the base metal, which is the self-repairing function of the dielectric film. In this embodiment, the following method utilizing hydrolysis of an organic compound was used for the formation of the above oxide film.

The starting materials for the organic compound are tantalum pentaethoxide (Ta(OC₂H₅)₅), acetic acid (CH₃COOH) and ethyl alcohol (C₂H₅OH). The solution made up of these materials is applied for example by the spin coating method which comprises dripping the solution on the substrate board revolving at 3,000 rpm, the dipping method which comprises immersing the substrate board in the above solution, or by the solution coating technology, for example the jet method which applies the solution under force to the substrate board. The coated board is then dried in the air at 120°C for 30 minutes and sintered at 400°C for 1 hour for the formation of an oxide film.

On this dielectric film, a film of high molecular material, e.g. pyrrole, is produced.

The conventional capacitor construction of oxide film-substrate metal-oxide film (dielectric film)-electrolyte provides the capacitor with a self-repairing function, that is to say the function of the dielectric film to repair itself by the oxidative action of the electrolyte on the base metal in the event of breakage of the dielectric film. In accordance with the present invention, however, which employs a conductive polymer film 14 capable of providing a local insulation at failure of the dielectric film 13 and accordingly maintaining the insulation between the capacitor electrodes, the presence of the base metal for the oxide film is no longer required.

Furthermore, compared with the conventional system (not more than 0.01 S/m) using MnO₂ or the like as the electrolyte, there is an additional advantage that the frequency characteristic of impedance is improved, as shown in Fig. 3, thanks to the use of a high polymer film which changes the equivalent series resistance of the capacitor to no less than 100 S/dm. Polypyrrole, which has a high electric conductivity and is chemically stable, is employed as the high polymer film 14 in this embodiment. The method for formation of this film is described below.

The above substrate board is first dipped in a solution of manganese nitrate and then sintered at a temperature of about 400°C to provide a MnO₂ film on the Ta₂O₅ film. This substrate board is then dipped in a bath composed of acetonitrile, tetraethylammonium tetrafluoroborate and monomeric pyrrole and at the same time the MnO₂ film is electrically energized to initiate electrolytic polymerization to provide a polypyrrole film 14, in a thickness of about 1 to 2 µm, on the MnO₂ film and, for that matter, on the Ta₂O₅ film.

In this process, the area other than the area for the capacitor on the MnO₂ film is previously masked so that the polypyrrole film will be selectively formed on the capacitor area.

The part of the MnO₂ film used as the polymerization electrode other than the part corresponding to the capacitor is removed by etching with diluted hydrochloric acid for insulation.

Then, to form the entire surface, i.e. the electrode 15 counter to the electrode 11, the polypyrrole film plus part of the dielectric film 13, is clad with copper. The process for this formation of a copper layer comprises a step of electroless copper plating to give a layer with a thickness of about 0.5 µm and a subsequent step of electrolytic plating using the same as the electrode 15 to provide a copper layer having the desired thickness.

The latter electrolytic plating process is carried out by using a plating bath composed of 200 to 250 g/ℓ of copper sulfate, 50 to 62 g/ℓ of copper metal, 30 to 75 g/ℓ of sulfuric acid and 50 to 120 mg/ℓ of chlorine at a current density of 0.5 to 5 A/cm² for the substrate and of 1 to 10 A/dm² for the copper electrode plate at a bath temperature of 20 to 50°C until a copper layer with a thickness of about 10 µm is obtained.

The laminated sheet 10 for use in the fabrication of a mixed circuit board of the invention is prepared by the above procedure. Then, the capacitor 31, resistor 32 and the conductor pattern are formed. For the formation of the capacitor 31, the static capacity value is set according to the three parameters of the opposed area of the electrode 11, the specific dielectric constant of the dielectric film and the thickness of the dielectric film. For the formation of the resistor 32, a part of electrode 11 is selectively etched, by the photoetching technique, in respect to width W and length L, and the resistance value is set according to this size and the sheet resistance of Ni alloy. The etching of copper and Ni alloy is respectively performed as follows.

First, in the etching of copper, the wiring pattern and capacitor 31 area are protected by a resistor film and the remaining area is treated in a solution of sodium perchlorate or potassium perchlorate at 40 to 50°C for 1 to 2 minutes to selectively remove the copper.

Thereafter, the area, WxL, to be left for use as the resistor 32 is protected with a resistor film and the Ni alloy is removed by etching using an amine type strongly alkaline solution at 90°C for 1 to 2 minutes to form the resistor 32.

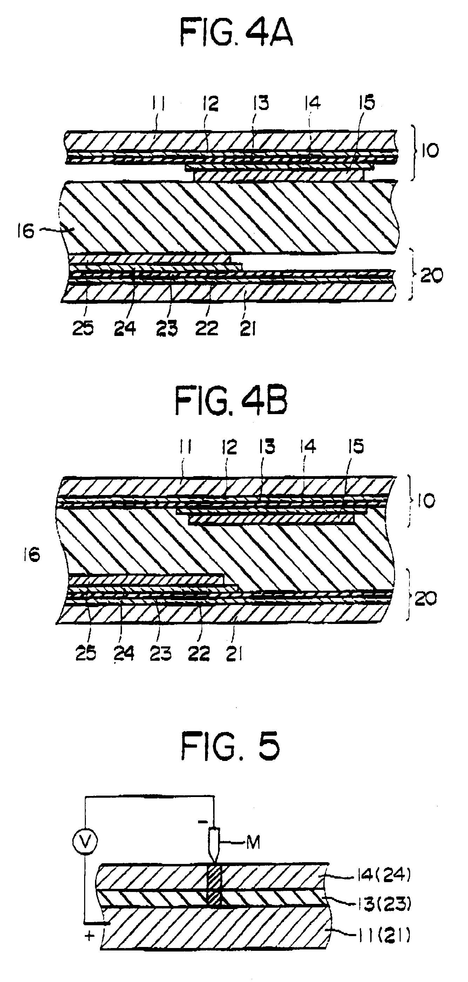

The first and second laminated sheets 10 and 20 fabricated in the above manner are set up with an epoxy resin substrate 16 interposed therebetween as illustrated in Fig. 4a and compressed to provide an integral unit as shown in Fig. 4b.

The through hole 33 between the capacitor electrodes 15,25 and the through holes 34,35 for connection between the wiring surfaces are formed as follows. With the counter electrode 15 exposed to through holes 36, 37 and 38 formed in the epoxy resin substrate 16, the through holes are electrolytically copper-plated for connection to the other wiring.

The diameter of the through holes in this embodiment is 0.3 mm. The method for plating these small-diameter through holes is described below.

The pretreatment for through-hole copper plating comprises washing with isopropyl alcohol, roughening by the etching technique, passivation with stannus chloride, and activation with palladium chloride.

After completion of the above pretreatment, electroplating is carried out by dipping the board in a mixed plating bath composed of copper sulfate, sulfuric acid and chlorine.

Thus, for this through-hole plating, a pretreatment similar to that for the conventional electroless copper plating is performed and the formation of the copper layer only is carried out by electroplating.

In the above arrangement, mere attachment of the first and second laminated sheets 10,20 on both sides of the insulating epoxy resin substrate 16 results in the proper positioning of not only the resistor 32 but also the capacitor 31 within the wiring pattern plane, thus contributing to high-density instrumentation.

Furthermore, since the formation of dielectric layers 13,23 does not require an anodic oxidation process, the circuit pattern can be constructed in an early stage of fabrication and the range of selection of production processes and raw materials is broadened.

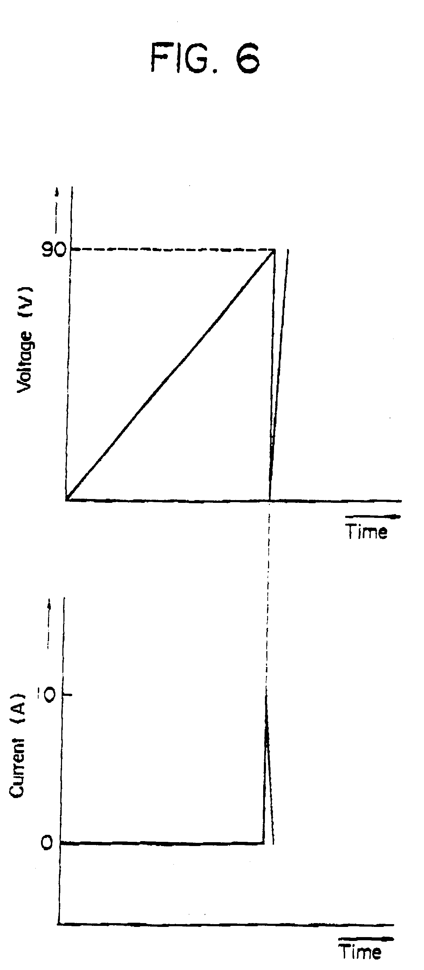

Particularly, in the above arrangement, the local insulating effect of the conductive polymer film 14(24) at breaks in the dielectric film 13(23) due to a short-circuit between the electrodes 11(21) and 15(25) ensures maintenance of capacitor characteristics. This local insulating effect of the conductive polymer film 14(24) can be demonstrated by using an insulation experimental model as shown in Fig. 5. Thus, using the copper electrode 11(21) as the positive electrode and the Pt terminal M as the negative electrode, this Pt terminal M is contacted with the conductive polymer film 14(24) to apply a voltage exceeding the withstand voltage of the dielectric film 13(23). As the voltage is gradually increased as shown in Fig. 6, a local insulation breakdown occurs in the dielectric film 13(23) at about 90V (shaded area in Fig. 5) and the current shoots up to the current limit of the power source as shown in Fig. 6.

An arc is produced at this moment and owing to its thermal energy, the conductive polymer film 14(24) is locally converted to an insulating film in correspondence with the insulation breakdown as indicated by shading in Fig. 5, with the result that the current returns to 0 and the voltage to 90V as shown in Fig. 6.

Incidentally, this type of conductive polymer film 14(24) is prepared by subjecting the starting material polymer to a special processing procedure such as doping with a donor or acceptor molecule, such as iodine or ferric chloride, so as to impart electrical conductivity to the raw material which is inherently dielectric. It is, therefore, considered that the local breakdown of the high polymer film 14(24) in the region where the short-circuit current flowed causes the re-conversion of the polymer film to the original insulator.

By the above conversion, the insulation between the electrodes 11(21), 15(25) is re-established and, hence, the capacitor characteristics are repaired.

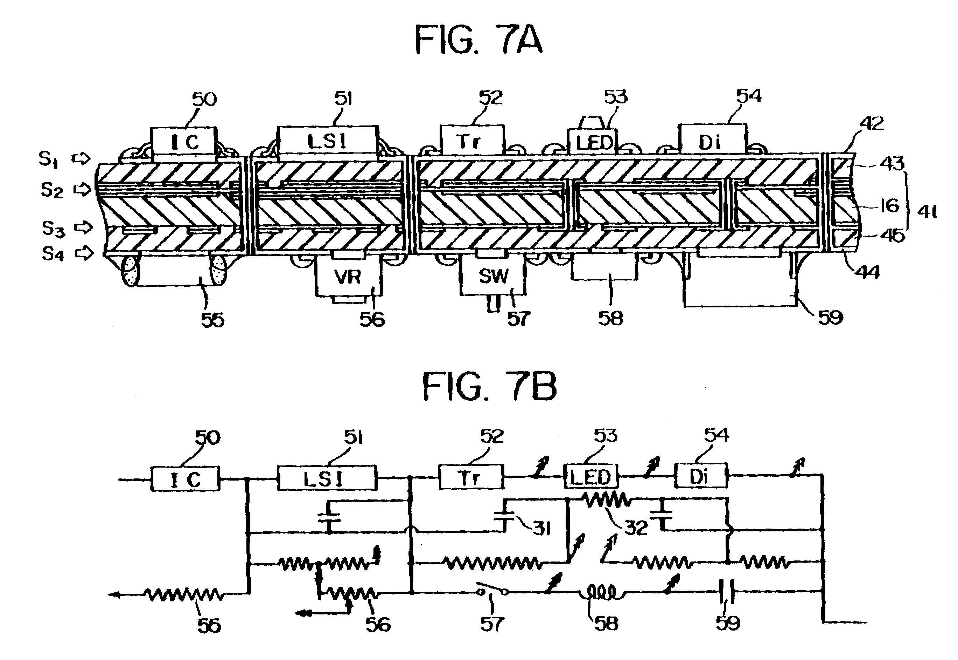

Fig. 7a and 7b show an example of application of the above mixed circuit board 41.

The construction of the illustrated mixed circuit board 41 consists of the first laminated sheet 10 bonded to one side of the epoxy resin substrate 16 and the second laminated sheet 20 having the resistor film 22 only to the other side. Here, the above circuit board 41 is sandwiched between a prepreg 43 of insulating synthetic resin clad with copper foil 42 and a prepreg 45 of insulating synthetic resin clad with copper foil 44.

Bonding of the above prepregs 43,44 to the board 41 is effected by compressing and heating the assemblage by means of a vacuum laminating press to melt the prepregs while removing voids between the layers of prepregs 16, 44 and 45 and causing them to cure in such a manner that the cured resin will seal off the respective films constituting the resistor 32 and capacitor 31 of the board 41 to give an integral product without boundary gaps between the prepreg layers 16,44,45.

It is common practice to coat the dielectric film 13 and resistor film 12 in discrete areas with an insulating synthetic resin or seal the package to protect against changes in environmental factors but in the above system of melting the prepregs 44 and 45 for sealing and bonding to the board 41, not only the trouble of coating can be omitted but the necessary protection against changes in environment can be easily insured.

In the arrangement illustrated in Fig. 7a and 7b the first layer S1 is used chiefly for the mounting of driver elements such as IC 50, LSI 51, transistor 52, light-emitting diode 53 and diode 54. The fourth layer S4 is used for the mounting of a special resistor such as a high consumption power resistor 55, a high-voltage, large-capacity capacitor such as an electrolytic capacitor 59, and even coils, which cannot be built into the second and third layers S2,S3. The fourth layer S4 is also used for elements having movable parts, such as variable resistor 56 and switch 57.

The wiring between the electronic components in the first layer S1 and fourth layer S4 and the circuits in the second layer S2 and third layer S3 can be effected by the usual through-hole processing method and pattern photoetching method. The connection between the electronic components in the first and fourth layers S1,S4 and the electrodes can be effected by the usual soldering technique.

As the electrode 11, electrolytic copper foil can also be employed. The electrolytic copper foil has heretofore been used as a wiring material for the PCB. Because the foil is made from the powdery material, it has an appropriately coarse surface and, unlike rolled copper foil, need not be roughened.

The formation of the dielectric films 13,23 may be effected by the cathode sputtering technique.

In this process, using the film material (Ta, target) as the negative electrode and the substrate board as the positive electrode, a voltage of 1.5 to 7 KV is applied between the electrodes to cause an abnormal glow discharge. The cathode current density is 0.15 to 1.5 mA/cm², the gas pressure is 1 to 10 x 10⁻² Torr, the distance between the electrodes is not less than 2 times the thickness of the dark region of the negative electrode, and the atmosphere within the reactor is an active gas (O₂). By this method, dielectric (Ta₂O₅) films 13,23 having a uniform thickness can be produced on a substrate with a large surface area.

The formation of the dielectric films 13,23 can also be effected by the ion plating technique. Thus, in an atmosphere of argon gas mixed with 5 to 25 x 10⁻³ Torr of oxygen gas, the metal Ta is vaporized by electron-beam heating and the Ta atoms in atomic state deposit on the substrate caused by the glow discharge generated by applying a negative high voltage of -500V to -5,000V to the substrate board as the negative electrode. In this method, the deposition speed, i.e. the rate of formation of the dielectric film, can be increased, thus contributing greatly to increased productivity.

The formation of dielectric films 13,23 can also be effected by the vacuum vapor deposition technique. Thus, in a vacuum, the film-forming material (Ta₂O₅) is vaporized by electron beam heating and the vapor is condensed on the cold substrate. While the film thickness is hardly controllable in this process, the technique is the simplest and most expedient of all the dry plating methods.

The dielectric film 13(23) can also be produced by melt blasting. This process comprises heating the material in the form of a wire, bar or powder with a flame of combustion of a mixture of oxygen with a combustible gas and blasting the completely or substantially molten material against the substrate to form a film. Another alternative blasting method is the plasma blasting technique utilizing a plasma jet for heating. The former process is used when emphasis is placed on productivity and economics, while the latter technique is recommended when adhesiveness of the substrate and the purity of the film are of important consideration.

While the oxide of Ta, viz. Ta₂O₅, is used for the dielectric film 13(23) in the above embodiment, other oxides such as TiO₂, Al₂O₃, etc. can also be indicated. Both TiO₂ and Al₂O₃ have satisfactory characteristics for application as capacitor dielectrics. The film of TiO₂ is an exceedingly stable oxide film with a dielectric constant of 65 which is approximately 3-fold as high as that of Ta₂O₅. On the other hand, a film of Al₂O₃ is a dielectric film with a withstand voltage of not less than 500 V and a small leak current. The formation of such oxide films can be carried out by the same techniques as those mentioned for Ta₂O₅.

While, in the above embodiment, polypyrrole is used for the conductive polymer film 14(24), polythienylenevinylene (hereinafter referred to briefly as PTV) can be used instead. PTV is a comparatively stable material having a conductivity comparable to that of polypyrrole and showing a strong interaction with various dopants. This material is advantageous in that it does not require a curing process for the formation of a film.

To produce this film, the Ta₂O₅ layer is coated with a 2 wt. % DMF (N,N-dimethylformamide) solution of a soluble intermediate of poly-2,5-thenylenevinylene and after drying with nitrogen gas streams, is heat-treated in an inert gas (N₂) atmosphere at 250°C for 3 hours. The selective PTV film formation is effected by etching off the unwanted area with an alcoholic solvent in semi-hardened state at an elevated temperature of 100°C.

The formation of the conductive polymer film 14(24), e.g. the polypyrrole film, can be effected by chemical oxidative polymerization with an oxidizing agent and subsequent electrolytic polymerization of the conductive polymer film.

For the chemical oxidative polymerization, the substrate is coated with pyrrole monomer and immersed in an oxidation bath containing 1 mol/l of FeCl₃. Using this conductive polymer film as the electrode, the polypyrrole is subjected to selective electrolytic polymerization in the same manner as described hereinbefore. Thereafter, the polypyrrole film in the area other than the area of the capacitor used as the electrode is removed with an organic solvent type etching solution.

As the insulating material 16, a ceramic material (e.g. Al₂O₃) can be used in lieu of epoxy resin.

Thus, a ceramic substrate is first selectively plated with electrode copper to form a circuit.

For electroless copper plating, the surface of the ceramic substrate is decreased with isopropyl alcohol, roughened with hydrofluoric acid, passivated with stannous chloride, and activated with palladium chloride. Then, the treated substrate is plated using a mixed plating bath composed of copper sulfate, EDTA sodium and formalin (pH 12.5) at 60°C. Then, the copper is selectively etched off with ferric chloride to provide a circuit.

Then, a dielectric film of tantalum oxide (Ta₂O₅) is formed all over the surface by the aforementioned method utilizing the hydrolysis of an organic compound. As a conductive polymer film, polythienylenevinylene (PTV) is selectively applied to the capacitor area.

After the selective formation of a PTV film in the capacitor area, a light-curable polyimide resin is coated on the remaining area, exposed, developed and baked at 250°C for 10 minutes to provide a film. By this film formation, the resistor film to be described hereinafter is rendered flat and smooth for improved reliability of resistance value.

On the above polymer film, a Ni alloy resistor film and a copper electrode film 21 are successively formed. The formation of a Ni alloy film on the polymer film can be carried out in the same manner as the aforementioned electroless plating method using a treating bath containing chromium chloride and sodium hypochlorite. The copper electrode to be disposed on this resistor film can also be produced by the electroless copper plating method described hereinbefore. The formation of the resistor film circuit network and resistors can be performed by the same etching techniques as described hereinbefore. Lastly, through holes are made for interconnection of capacitor electrodes and wirings.

Ceramics are generally hard and brittle and, in this sense, are inherently difficult to work on. In the present invention, such a ceramic substrate is clad with a metal film, while through holes must be as fine as about 0.3 mm in diameter. Therefore, the processing of through holes must be performed with due respect to the differences between the two materials in mechanical and physical properties. Among the processing techniques meeting such requirements are electron beam processing and laser beam processing. The former technique is employed when efficiency weighs the most, while the latter is recommended when economics and workmanship are the most important considerations. The through holes thus made are finally plated for interconnection of the electrodes.

As the resistor film material, Ni-W-P can be used as a low to medium resistor material, while Ni-P can be used as a high resistor material. Aside from them, various other Ni alloys such as Ni-B-W, Ni-P-Cu, Ni-B-Cu, Ni-Cr, Cu-Ni, etc. can also be employed. Moreover, Cu-Mn, Ag-Mn, Au-Cr and other metals may also be used as resistor film materials. Such other metal compounds as TaN can also be applied by the reactive sputtering technique.

## Claims

1. A mixed circuit board comprising a heat-resistant insulating substrate (16) and at least one laminated sheet (10,20) bonded integrally to at least one side of said substrate (16);
characterised in that:
said laminated sheet comprises a metal oxide dielectric film (13), a metal resistor film (12) on said dielectric film and a pair of metal conductor layers (11,15) between which said dielectric film (13) and resistor film (12) are sandwiched.

2. A mixed circuit board comprising a heat-resistant insulating substrate (16) and at least one laminated sheet (10,20) bonded integrally to at least one side of said substrate (16);
characterised in that:
said laminated sheet comprises a metal oxide dielectric film (13), a conductive polymer film (14), a metal resistor film (12) on either said conductive polymer film (14) or said dielectric film (13) and a pair of metal conductor layers (11,15) between which said dielectric film (13), said conductive polymer film and resistor film (12) are sandwiched.

3. A method for fabricating a mixed circuit board which comprises:
a step of forming a metal oxide dielectric film (13),
a step of forming a conductive polymer film (14) on the surface of said dielectric film (13),
a step of forming a metal oxide resistor film (12) on either said dielectric film (13) or said conductive polymer film (14),
a step of sandwiching said dielectric film (13), said conductive polymer film (14) and said resistor film (12) between a pair of metal conductor layers (11,15),
a step of forming an insulating region by selective etching of at least one of said metal conductor layers (11,15) in a circuit network formation, and
a step of bonding a laminated sheet (10,20) consisting of said dielectric film (13), conductive polymer film (14), resistor film (12) and metal conductor layers (11,15) to at least one side of a heat-resistant insulating substrate (16).

## Patentansprüche

1. Mischleiterplatte, ein hitzebeständiges isolierendes Substrat (16) und zumindest eine laminierte Bahn (10,20), die einstückig mit zumindest einer Seite des Substrats (16) fest verbunden ist, umfassend, dadurch gekennzeichnet, daß
die laminierte Bahn einen dielektrischen Metalloxidfilm (13), einen metallischen Widerstandsfilm (12) auf dem dielektrischen Film und ein Paar Metalleiterschichten (11,15), zwischen die der dielektrische Film (13) und der Widerstandfilm (12) eingelegt sind, umfaßt.

2. Mischleiterplatte, ein hitzebeständiges isolierendes Substrat (16) und zumindest eine laminierte Bahn (10,20), die einstückig mit zumindest einer Seite des Substrats (16) fest verbunden ist, umfassend, dadurch gekennzeichnet, daß
die laminierte Bahn einen dielektrischen Metalloxidfilm (13), einen leitenden Polymerfilm (14), einen metallischen Widerstandsfilm (12) auf entweder dem leitenden Polymerfilm (14) oder dem dielektrischen Film (13) und ein Paar Metalleiterschichten (11,15), zwischen die der dielektrische Film (13), der leitende Polymerfilm (14) und der Widerstandsfilm (12) eingelegt sind, umfaßt.

3. Verfahren zur Herstellung einer Mischleiterplatte, umfassend:
einen Schritt des Bildens eines dielektrischen Metalloxidfilms (13),
einen Schritt des Bildens eines leitenden Polymerfilms (14) auf der Oberfläche des dielektrischen Films (13),
einen Schritt des Bildens eines Widerstandsfilms (12) aus Metalloxid auf entweder dem dielektrischen Film (13) oder dem leitenden Polymerfilm (14),
einen Schritt des Einlegens des dielektrischen Films (13), des leitenden Polymerfilms (14) und des Widerstandsfilms (12) zwischen ein Paar Metalleiterschichten (11,15),
einen Schritt des Bildens eines isolierenden Bereichs durch selektives Ätzen von zumindest einer der Metalleiterschichten (11,15) in einer Schaltungsnetzwerkgestaltung, und
einen Schritt des festen Verbindens einer laminierten Bahn (10,20), bestehend aus dem dielektrischen Film (13), dem leitenden Polymerfilm (14), dem Widerstandsfilm (12) und den Metalleiterschichten (11,15) mit zumindest einer Seite eines hitzebeständigen isolierenden Substrats (16).

## Revendications

1. Une plaque de circuits imprimés composite comprenant un substrat isolant résistant à la chaleur (16) et au moins une feuille laminée (10, 20) collée intégralement sur au moins une face dudit substrat (16);
caractérisé en ce que :
ladite feuille laminée comprend un film diélectrique en un oxyde métallique (13), un film de résistance métallique (12) sur ledit film diélectrique et une paire de couches conductrices métalliques (11, 15) entre lesquelles ledit film diélectrique (13) et le film de résistance (12) sont disposés en sandwich.

2. Une plaque de circuits imprimés composite comprenant un substrat isolant et résistant à la chaleur (16) et au moins une feuille laminée (10, 20) collée intégralement sur au moins un côté ou face dudit substrat (16);
caractérisé en ce que :
ladite feuille laminée comprend un film diélectrique en oxyde métallique (13), un film polymère conducteur (14), un film de résistance métallique (12) sur ledit film polymère conducteur (14) ou ledit film diélectrique (13) et une paire de couches conductrices métalliques (11, 15) entre lesquelles ledit film diélectrique (13), ledit film polymère conducteur et le film de résistance (12) sont disposés en sandwich.

3. Procédé pour fabriquer une plaque de circuits imprimés composite comprenant :
une opération de formation d'un film diélectrique en oxyde métallique (13),
une opération de formation d'un film polymère conducteur (14) sur la surface dudit film diélectrique (13),
une opération de formation d'un film de résistance en oxyde métallique (12) sur ledit film diélectrique (13) ou ledit film polymère conducteur (14),
une opération de disposer en sandwich ledit film diélectrique (13), ledit film polymère conducteur (14) et ledit film de résistance (12) entre une paire de couches conductrices métalliques (11, 15),
une opération de former une région isolante par attaque chimique sélective d'au moins une desdites couches conductrices métalliques (11, 15) dans une formation de réseau de circuits, et
une opération de coller une feuille laminée (10, 20) formée par ledit film diélectrique (13), le film polymère conducteur (14), le film de résistance (12) et les couches conductrices métalliques (11, 15) sur au moins une face d'un substrat isolant et résistant à la chaleur (16).
